# EUROPÄISCHE PATENTSCHRIFT

(11) **EP 1 509 992 B1**
(45) Veröffentlichungstag und Bekanntmachung des Hinweises auf die Patenterteilung: **17.10.2007**
(21) Anmeldenummer: 03732497.7
(22) Anmeldetag: 28.05.2003
(51) Int. Cl.: H02M 7/00

(54) **SCHALTUNGSANORDNUNG ZUR STEUERUNG ELEKTROMOTORISCHER ANTRIEBSMITTEL EINES FAHRBAREN ARBEITSGERÄTES, INSBESONDERE EINES FLURFÖRDERZEUGS**
CIRCUIT ARRANGEMENT FOR CONTROLLING ELECTROMOTIVE DRIVING MEANS OF A MOBILE WORKING MACHINE, PARTICULARLY OF AN INDUSTRIAL TRUCK
CIRCUIT POUR COMMANDER UN MOYEN D'ENTRAINEMENT PAR MOTEUR ELECTRIQUE D'UN OUTIL ROULANT, EN PARTICULIER D'UN CHARIOT DE MANUTENTION

(30) Priorität: 31.05.2002 DE 10224168; 02.07.2002 DE 20210217 U
(43) Veröffentlichungstag der Anmeldung: 02.03.2005
(73) Patentinhaber: Jungheinrich Moosburg GmbH, 85368 Moosburg (DE)
(72) Erfinder: KOLLMANNSBERGER, Otto, 85368 Moosburg (DE); RIES, Michael, 63741 Aschaffenburg (DE)
(74) Vertreter: Tiesmeyer, Johannes
(86) Internationale Anmeldenummer: PCT/EP2003/005664
(87) Internationale Veröffentlichungsnummer: WO 2003/103125

(56) Entgegenhaltungen:
- DE-A- 4 027 244
- DE-A- 4 412 407
- US-A- 5 617 307

## Beschreibung

Die Erfindung betrifft eine Schaltungsanordnung zur Steuerung elektromotorischer Antriebsmittel eines fahrbaren Arbeitsgerätes, insbesondere eines Flurförderzeugs, gemäß dem Oberbegriff des Anspruchs 1.

Es sind Flurförderzeuge, z.B. Elektro-Gabelstapler, bekannt, welche wenigstens einen Elektromotor, beispielsweise Drehstrom-Elektromotor als Fahrantriebsmotor, einen weiteren Elektromotor als Lenkmotor, also als Antriebsmittel für die Lenkbewegungen eines lenkbaren Rades oder ggf. mehrerer lenkbarer Räder, und einen weiteren Elektromotor als Pumpenmotor umfassen. Der Pumpenmotor treibt eine Hydraulikpumpe der hydraulischen Hubeinrichtung des Flurförderzeugs an.

Die Elektromotoren, insbesondere der Fahrantriebsmotor und der Pumpenmotor, sind sehr leistungsstarke Antriebsmittel und für einen großen Betriebsstrombedarf dimensioniert. Der Betriebsstrom wird von der Bordbatterie des Staplers geliefert, die je nach Ausführungsform eine Nennspannung von beispielsweise 24 V, 48 V oder 80 V haben kann. Der Strombedarf des Fahrantriebsmotors und des Pumpenmotors kann abhängig von den Betriebsbedingungen bei mehreren hundert Ampere liegen. Die Elektromotoren werden über eine Leistungsendstufe in gesteuerter Weise mit Strom aus der Bordbatterie versorgt.

Vorteilhafterweise sind zumindest die meisten elektronischen bzw. elektrischen Bauelemente der Leistungsendstufe, wie etwa die Leistungstransistoren, auf einer gemeinsamen Platine bzw. Karte vorgesehen.

Eine elektronische Steuerstufe dient zur Steuerung der Leistungsendstufe in Abhängigkeit von Sollwert- und Istwertsignalen. Sollwertsignale werden z.B. von elektronischen Gebern bereitgestellt, die auf die Betätigung zugeordneter Bedienungselemente ansprechen. Ein Sollwertsignal für die Steuerung des Fahrantriebsmotors wird von einem Fahrpedalbetätigungssensor geliefert und ist ein Maß für die Sollgeschwindigkeit des Flurförderzeugs. Ein weiteres Sollwertsignal ist das von einem Fahrtrichtungsgeber nach Maßgabe der Betätigung eines Fahrtrichtungsschalters gelieferte Fahrtrichtungssignal.

Ein Sollwertsignal zur Steuerung des Lenkmotors kann beispielsweise von einem Lenkwinkelgeber bereitgestellt werden, der ein Signal nach Maßgabe der Betätigung des Lenkrades des Flurförderzeugs bereitstellt.

Sollwertsignale zur Steuerung des Pumpenmotors werden von Geberelementen geliefert, welche an Bedienungselementen zur Einstellung des Hub- und Senkbetriebes usw. der hydraulischen Hubeinrichtung angeschlossen sind.

Istwertsignale erhält die elektronische Steuerstufe von den diversen Istwertgebern, welche z. B. zur Messung der aktuellen Fahrgeschwindigkeit, des momentanen Lenkwinkels der lenkbaren Räder, des jeweiligen Hubzustandes der hydraulischen Hubeinrichtung usw. vorgesehen sind.

Die elektronische Steuerstufe umfasst üblicherweise eine Vielzahl von elektronischen Bauelementen. Darunter sind integrierte Schaltkreise, wie etwa Mikroprozessoren, Speicherbausteine, Ein-/Ausgabebausteine, und ferner Sensorschaltungen sowie Treiberschaltungen für die Leistungstransistoren der Leistungsendstufe. Die elektronische Steuerstufe bekannter Schaltungsanordnungen umfasst überdies Steckverbindungselemente für den Anschluss von Signalleitungen und Datenbusleitungen, einen oder mehrere Temperatursensoren, Sicherheitsschaltelemente, wie ein Notstopprelais, und Anzeigeelemente, wie etwa Leuchtdioden oder LCD-Displayelemente.

Aus der gattungsbildenden DE 40 27 244 A1 ist ein Regler für mit einer Resolverrückführung ausgerüstete Servomotoren mit auf einer Leiterplatte als Grundplatte angeordneten Schaltelementen eines Leistungsteils und eines Steuerteils mit Leistungsansteuerung, Sicherungsfunktionen und Sinuskommutierung bekannt.

Die Grundplatte dieses Reglers weist eine Steckerleiste zur Verbindung mit dem Servomotor und einen weiteren Anschluss zur Verbindung des Reglers mit einem Positioniermodul auf. Zusätzlich zur Grundplatte ist eine zweite, getrennte mittels eines Steckers auf der Grundplatte an die Grundplatte anzukoppelnde Leiterplatte als Wechselplatte vorgesehen, auf der Schaltungselemente zur Übertragung der aus der Sinuskommutierungsbaugruppe gewonnenen Winkelinformation an das Positioniermodul angeordnet sind.

Die Bauelemente der elektronischen Steuerstufe sind bei den bekannten Beispielen auf einer gemeinsamen Steuerstufenplatine vorgesehen. Das Layout dieser Steuerstufenplatine und somit die Anordnung der zugehörigen elektronischen Bauelemente wurden im Wesentlichen unter dem Gesichtspunkt der Platzoptimierung, im Falle der erwähnten DE 40 27 244 A1 auch unter dem Gesichtspunkt der Funktion der Bauelemente, gewählt. Die Unterbringung der Steuerstufenbauelemente auf wenigstens einer von der Leistungsendstufenplatine gesonderten Steuerstufenplatine ist zweckmäßig, um die normalerweise temperaturempfindlichen Steuerstufenbauelemente von der Leistungsendstufe möglichst gut und mit einfachen Mitteln thermisch isolieren zu können.

Falls die relativ empfindliche Steuerstufe einen Defekt zeigen sollte, so kann diesbezüglich Abhilfe geschaffen werden, indem sie durch eine einwandfreie Steuerstufenplatine ausgetauscht wird. Aufgrund der Vielzahl hochwertiger elektronischer Bauelemente auf der Steuerstufenplatine ist ein solcher Austausch jedoch mit beträchtlichen Kosten verbunden.

Eine Reparatur einer defekten Steuerstufenplatine ist üblicherweise unwirtschaftlich, da die Fehleranalyse und das Auswechseln von Bauelementen der hochdicht bestückten Platine aufwendige und komplizierte Maßnahmen sind.

Für den Hersteller der hier betrachteten Schaltungsanordnungen bzw. der damit ausgerüsteten Arbeitsgeräte kann sich überdies das Problem stellen, dass er bei dem Verkauf seines Produktes in verschiedenen Ländern unterschiedliche Steckeranschlussnormen für Datenübertragungs-Schnittstellen der Steuerstufe zu berücksichtigen und somit entsprechende Varianten seiner Schaltungsanordnung bereitzuhalten hat.

Der Erfindung liegt die Aufgabe zugrunde, die vorstehend genannten Nachteile der bekannten Schaltungsanordnungen zu überwinden und eine Schaltungsanordnung der eingangs genannten Art bereitzustellen, die in den meisten Fällen eine schnellere, einfachere und kostengünstigere Behebung von Störungen bzw. Ausfällen der elektronischen Steuerstufe ermöglicht.

Zur Lösung dieser Aufgabe wird eine Schaltungsanordnung der eingangs genannten Art mit den Merkmalen des Kennzeichens des Anspruchs 1 vorgeschlagen.

Die Erfindung beruht somit auf dem Konzept, Bauelemente der Steuerstufe, die sich als besonders verschleißanfällig und somit austauschbedürftig erwiesen haben, oder/und Bauelemente der Steuerstufe, die relativ häufig zu überprüfen sind und daher leicht zugänglich sein sollten, auf der Wechselplatine zu versammeln.

Soweit die verschleißanfälligeren Bauelemente der Steuerstufe auf der Wechselplatine vorgesehen sind, ist ein Defekt der Steuerstufe mit großer Wahrscheinlichkeit dadurch zu beheben, dass die Wechselplatine ausgetauscht wird. Die Anzahl an Bauelementen auf der Wechselplatine sollte möglichst gering gehalten werden, damit die Kosten der Wechselplatine gering bleiben. So sollte die Anzahl der Bauelemente auf der Wechselplatine möglichst geringer sein als 25 % der Anzahl der elektronischen Bauelemente der Steuerstufe insgesamt.

Aus Gründen der einfacheren Handhabbarkeit der Wechselplatine sollte deren Plattengröße möglichst gering sein und nicht mehr als ein Drittel der Plattengröße der Hauptplatine erreichen.

Vorzugsweise sind die Leistungsendstufenplatine, die Hauptplatine der Steuerstufe und die Wechselplatine der Steuerstufe in einem gemeinsamen Gehäuse untergebracht. In einer besonders bevorzugten Ausführungsform ist die Wechselplatine so dimensioniert, dass die durch eine in einem Seitenteil des Gehäuses vorgesehene Zugriffsöffnung hindurch von der Hauptplatine getrennt und aus dem Gehäuse entfernt bzw. in das Gehäuse eingebracht und mit der Hauptplatine elektrisch verbunden werden kann, wobei die Wechselplatine vorzugsweise an einer Deckelblende zum Verschließen der Zugriffsöffnung angeordnet ist.

Insbesondere wenn die elektrische Verbindung zwischen Hauptplatine und Wechselplatine gemäß einer Ausführungsform der Erfindung durch eine leicht lösbare Steckverbindung realisiert ist, kann der Austausch der Wechselplatine auf besonders einfache und schnelle Weise erfolgen.

Da die Wechselplatine bequem ausbaubar ist, besteht auch die Möglichkeit, die darauf befindlichen Bauelemente auf einfache Weise außerhalb des Gehäuses zu überprüfen.

Es liegt auch im Rahmen der Erfindung, Bauelemente der Steuerstufe auf der Wechselplatine zu versammeln, für die ein größerer Bedarf an herstellerseitig bereitzuhaltenden Varianten besteht als für die übrigen Bauelemente der Steuerstufe. Ein solcher größerer Bedarf an herstellerseitig bereitzuhaltenden Varianten an Bauelementen kann z.B. darin begründet sein, dass in unterschiedlichen Ländern unterschiedliche Steckeranschlussnormen bzw. Schnittstellentechnologien oder ggf. unterschiedliche Anforderungen bezüglich der Anzeigeelemente usw. bestehen. Durch Konzentrierung dieser von Fall zu Fall variierenden Bauelemente auf der Wechselplatine ist es dem Hersteller möglich, die Schaltungsanordnung im Übrigen in Serie und gleichartig auszubilden und lediglich die Wechselplatine den jeweiligen Forderungen entsprechend anzupassen.

Gegenstand der Erfindung ist auch ein fahrbares Arbeitsgerät, insbesondere ein Flurförderzeug, mit wenigstens einem Elektromotor, insbesondere wenigstens einem elektrischen Fahrmotor oder/und einem Elektromotor als Antriebsquelle für eine Hubeinrichtung oder/und einem elektrischen Lenkmotor, und mit einer Schaltungsanordnung nach der Erfindung zur Steuerung des wenigstens einen Elektromotors.

Die Erfindung wird im Folgenden unter Bezugnahme auf die Figuren näher erläutert.
- Fig. 1: zeigt in einer schematischen Darstellung eine mehrfach aufgebrochen gezeichnete Draufsicht auf eine Schaltungsanordnung nach der Erfindung.
- Fig. 2: zeigt eine schematische Blockdarstellung einer Schaltungsanordnung nach der Erfindung.

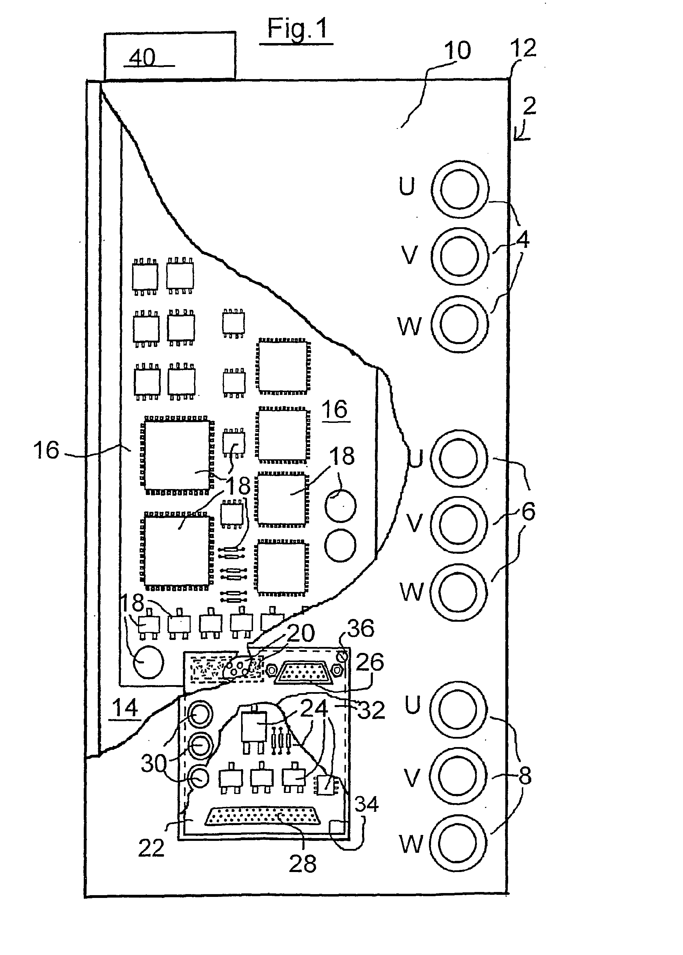

Bei dem in Fig. 1 gezeigten Gegenstand handelt es sich um ein Steuergerät für einen Elektrogabelstapler, der einen Drehstrommotor als Fahrantriebsmotor, einen weiteren Elektromotor als Lenkmotor und einen zusätzlichen Elektromotor als Pumpenmotor für die Hydraulikpumpe der hydraulischen Hubeinrichtung aufweist. Das Steuergerät 2 hat Stromversorgungsanschlüsse 4 für den Fahrantriebsmotor, Stromversorgungsanschlüsse 6 für den Pumpenmotor und Stromversorgungsanschlüsse 8 für den Lenkmotor. An diese Stromversorgungsanschlüsse 4, 6, 8 sind Starkstromkabel der betreffenden Motoren anzuschließen. Die Stromversorgungsanschlüsse 4, 6, 8 befinden sich an einem Seitenteil 10 des Gerätegehäuses 12. In dem Gerätegehäuse 12 sind die Stromversorgungsanschlüsse 4, 6, 8 mit einer Leistungsendstufe verbunden, welche aus einer in Fig. 1 zuunterst in dem Gehäuse 12 liegenden Platine 14 gebildet ist. Die Leistungsendstufenplatine 14 ist mit Endstufen-Bauelementenen (nicht gezeigt) bestückt. Hierzu zählen Leistungstransistoren zur Steuerung des Stromflusses von der Batterie des Elektrogabelstaplers zu dem Fahrantriebsmotor, dem Lenkmotor bzw. dem Pumpenmotor. Bei diesen Leistungstransistoren kann es sich z.B. um MOSFET-Transistoren handeln. Die Leistungsendstufenplatine 14 kann ferner mit EMV-Filterbauelementen, Kühlelementen, Temperaturmessungskomponenten usw. bestückt sein.

Die Anschlüsse für die Verbindung des Steuergerätes 2 mit der Bordbatterie sind in Fig. 1 nicht erkennbar.

Oberhalb der in dem Gehäuse 12 fixierten Leistungsendstufenplatine 14 befindet sich die Hauptplatine 1 6 der elektronischen Steuerstufe, wobei die Hauptplatine 16 über (nicht gezeigte) Pfostenleisten auf Abstand mit der Leistungsendstufenplatine 14 verschraubt ist. Die Hauptplatine 16 der zur Steuerung der Leistungsendstufe vorgesehenen Steuerstufe weist eine Vielzahl elektronischer Bauelemente 18 in einer betreffenden Beschaltung auf. Zu diesen elektronischen Bauelementen gehören Mikrokontroller bzw. Mikrocomputerelemente, wie etwa Mikroprozessoren, Speicherbausteine, I/O-Bausteine bzw. Schnittstellen- und Treiberbausteine. Die Hauptplatine 16 ist ferner mit Sensorelementen für die Strom-, Spannungs- und Drehzahlerfassung von Elektromotoren usw. bestückt und weist überdies Spannungsversorgungselemente und MOSFET-Treiberschaltungen für die Leistungsendstufe auf.

Über eine Steckverbindung 20 ist die Hauptplatine 16 mit einer Wechselplatine 22 elektrisch verbunden. Die Wechselplatine 22 gehört ebenfalls zu der Steuerstufe für die Leistungsendstufe 14. Die Wechselplatine 22 ist u. a. mit einer Auswahl von Bauelementen 24 bestückt, die eine größere statistische Ausfallwahrscheinlichkeit und somit eine geringere statistische Lebenserwartung haben als die Bauelemente 18 der Hauptplatine 16. Es soll bei dem gezeigten Ausführungsbeispiel jedoch nicht ausgeschlossen sein, dass auch auf der Wechselplatine 22 unempfindliche bzw. langlebige Bauelemente untergebracht sind. Wie in Fig. 1 erkennbar, sollte jedoch die Anzahl an Bauelementen auf der Wechselplatine 22 möglichst klein im Vergleich mit der Anzahl an Bauelementen auf der Hauptplatine 16 sein.

In einer bevorzugten Ausführungsform umfasst die Wechselplatine 22 Schaltungselemente einer Ladeschaltung zum Laden der Pufferkondensatoren der Leistungsendstufe. Zu diesen Schaltungselementen zählen unter anderem auch eine Entkopplungsdiode und ein temperaturabhängiger Widerstand, beispielsweise PTC-Widerstand.

Die Wechselplatine 22 weist ferner Elemente eines Sicherheitskreises auf, nämlich wenigstens ein Notstopprelais sowie Sensorelemente für ein Hauptschütz (nicht gezeigt).

Die Wechselplatine 22 weist ferner Anzeigeelemente 30 auf. Im Beispielsfall handelt es sich hierbei um Leuchtdioden. Ferner sind auf der Wechselplatine 22 wenigstens eine physikalische Schnittstelle (Transceiver) und Abschlusswiderstände für ein CAN-Bussystem vorgesehen. Des Weiteren befinden sich Steckverbindungselemente 26 von RS232-Schnittstellen auf der Wechselplatine 22.

Die Wechselplatine 22 ist lösbar an einer in Fig. 1 aufgebrochen dargestellten Deckelblende 32 befestigt, die eine Zugriffsöffnung 34 in dem Seitenteil 10 des Gehäuses 12 verschließt. Die Deckelblende 32 ist mit dem Seitenteil 10 verschraubt. Eine Verschraubungsstelle ist bei 36 zu erkennen.

Wie aus Fig. 1 zu ersehen, ist die Wechselplatine 22 so groß, dass sie nach Lösung der betreffenden Schrauben 36 durch die Zugriffsöffnung 34 hindurch aus dem Gehäuse 12 entfernt werden kann. Dabei wird die Steckverbindung 20 automatisch getrennt. Auf entsprechend einfache Weise kann die Wechselplatine 22 wieder unter Herstellung der Steckverbindung 20 in das Gehäuse 12 eingebracht und dabei funktionsfähig installiert werden. Die vorstehenden Erläuterungen lassen unmittelbar erkennen, dass der Ausbau und der Einbau von Wechselplatinen 22 auf einfache Weise sehr schnell erfolgen kann, sei es zum Zwecke des Austausches der Wechselplatine 22 oder zum Zwecke der Überprüfung der Bauelemente 24, 26, 28, 30.

Da die Bauelemente mit der größten Ausfallwahrscheinlichkeit auf der Wechselplatine 22 vorgesehen sind, lassen sich Störungen der Steuerstufe mit relativ hoher Wahrscheinlichkeit dadurch beheben, dass die Wechselplatine 22 ausgetauscht wird. Da die Wechselplatine 22 mit vergleichsweise wenigen Bauelementen bestückt ist, kann es durchaus sinnvoll sein, defekte Bauelemente der Wechselplatine 22 per Fehleranalyse ausfindig zu machen und auszutauschen bzw. zu reparieren, um dann die Wechselplatine 22 wieder in Benutzung zu nehmen.

Mit 40 ist in Fig. 1 eine Lüftereinrichtung gekennzeichnet, die zur Kühlung der Schaltungsanordnung, insbesondere der Leistungsendstufe 14 vorgesehen ist.

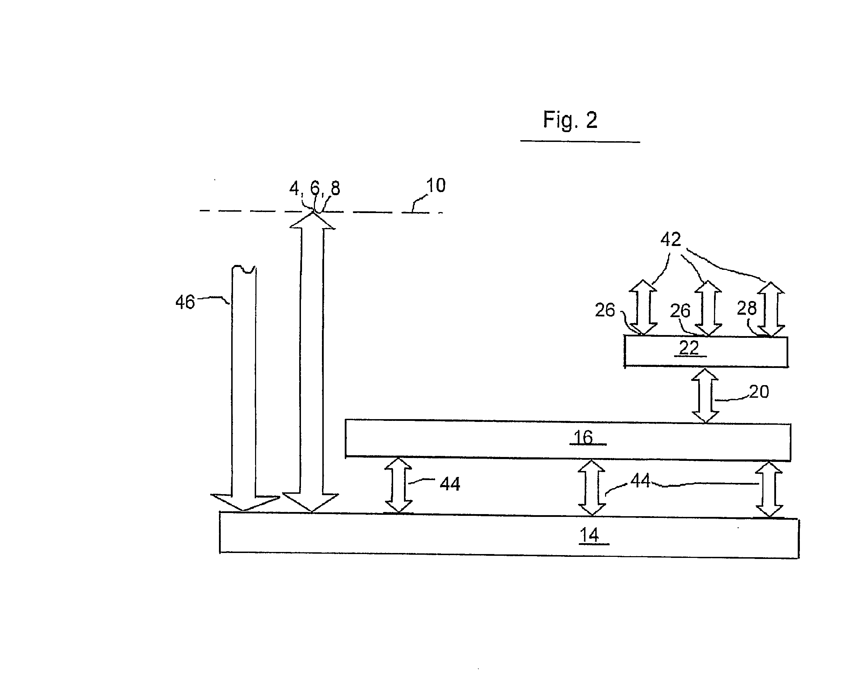

In Fig. 2 ist ein Blockschaltbild der in dem Steuergerät nach Fig. 1 vorgesehenen Schaltungsanordnung dargestellt. Darin ist zu erkennen, dass die Wechselplatine 22 vermittels ihrer Schnittstellenanschlüsse 26, 28 mit externen Signalübertragungsleitungen bzw. Datenübertragungsleitungen 42 verbunden ist, die andererseits mit externen Gebern, Motorsensoren, Fahrzeugsensoren und ggf. einer zentralen Steuereinheit des Gabelstaplers verbunden sind.

Die Wechselplatine 22 ist über die Steckverbindung 20 mit der Hauptplatine 16 verbunden. Die Hauptplatine 16 ist über die Anschlüsse 44 mit der Leistungsendstufenplatine 14 elektrisch verbunden, um die Leistungstransistoren für den Fahrantriebsmotor, den Pumpenantriebsmotor und den Lenkmotor zu steuern. Die Leistungsendstufenplatine 14 ist über Leitungen 46 an der Bordbatterie des Elektrogabelstaplers angeschlossen und gibt über die Leitungsanschlüsse 4, 6, 8 elektrische Energie in gesteuerter Weise an den bzw. die Elektromotoren ab.

## Patentansprüche

1. Schaltungsanordnung zur Steuerung elektromotorischer Antriebsmittel eines fahrbaren Arbeitsgerätes, insbesondere eines Flurförderzeugs,
wobei die Schaltungsanordnung eine elektronische Steuerstufe (16, 22) und eine Leistungsendstufe (14) umfasst, wobei die elektronische Steuerstufe wenigstens eine in einem Gehäuse (12) der Schaltungsanordnung fixierte und mit elektronischen Bauelementen bestückte Hauptplatine (16) und eine mit der Hauptplatine (16) elektrisch verbundene, jedoch bedarfsweise mit geringem Aufwand von der Hauptplatine (16) zu trennende Wechselplatine (22) aufweist,
**dadurch gekennzeichnet, dass** die Wechselplatine (22) eine Gruppe von ausgewählten Steuerstufenbauelementen (24) aufweist, für die aufgrund ihrer größeren Ausfallwahrscheinlichkeit statistisch ein größerer Austauschbedarf und/oder ein größerer Überprüfungsbedarf besteht als für die Bauelemente (18) der Hauptplatine (16).

2. Schaltungsanordnung nach Anspruch 1, wobei die Wechselplatine (22) durch wenigstens eine Steckverbindung (20) mit der Hauptplatine (16) elektrisch verbunden ist.

3. Schaltungsanordnung nach Anspruch 1 oder 2 , wobei die Wechselplatine (22) Steckverbindungselemente (26, 28) zum Anschluss von externen Signalleitungen, insbesondere von Datenübertragungsleitungen aufweist.

4. Schaltungsanordnung nach einem der vorhergehenden Ansprüche, wobei die Wechselplatine (22) optische Anzeigeelemente (30) aufweist.

5. Schaltungsanordnung nach einem der vorhergehenden Ansprüche, wobei anzahlmäßig maximal 25 %, insbesondere maximal 15% der elektronischen Bauelemente der Steuerstufe auf der Wechselplatine (22) vorgesehen sind.

6. Schaltungsanordnung nach einem der vorhergehenden Ansprüche, wobei die Plattengröße der Wechselplatine (22) maximal einem Drittel, insbesondere max. einem Viertel der Plattengröße der Hauptplatine (16) entspricht.

7. Schaltungsanordnung nach einem der vorhergehenden Ansprüche, wobei die Wechselplatine durch eine in einem Seitenteil (10) des Gehäuses (12) vorgesehene Zugriffsöffnung (34) hindurch von der Hauptplatine (16) getrennt und aus dem Gehäuse (12) entfernt werden bzw. in das Gehäuse (12) eingebracht und mit der Hauptplatine (16) elektrisch verbunden werden kann und wobei die Wechselplatine (22) an einer Deckelblende (32) zum Verschließen der Zugriffsöffnung (34) angeordnet ist.

8. Schaltungsanordnung nach einem der vorhergehenden Ansprüche, wobei die Leistungsendstufe eine mit Endstufenbauelementen bestückte Platine (14) aufweist, die elektrisch mit der Hauptplatine (16) der Steuerstufe verbunden und zusammen mit der Hauptplatine (16) und der Wechselplatine (22) der Steuerstufe in dem Gehäuse (12) untergebracht ist.

9. Fahrbares Arbeitsgerät, insbesondere Flurförderzeug, mit wenigstens einem elektrischen Fahrmotor oder/und einem Elektromotor für den Betrieb einer Hubeinrichtung oder/und einem elektrischen Lenkmotor, und mit einer Schaltungsanordnung nach einem der Ansprüche 1 bis 8 zur Steuerung des wenigstens einen Elektromotors.

## Claims

1. Circuit arrangement for controlling electromotive driving means of a mobile working machine, particularly of an industrial truck,
the circuit arrangement comprising an electronic control stage (16, 22) and a power output stage (14), the electronic control stage having at least one main circuit board (16) that is fixed in a housing (12) of the circuit arrangement and is populated with electronic components and an exchangeable circuit board (22) that is electrically connected to the main circuit board (16) but can be separated from the main circuit board (16) as required with little effort,
**characterized in that** the exchangeable circuit board (22) has a group of selected control stage components (24) for which, on account of their greater probability of failure, statistically, a greater need for exchanging and/or a greater need for checking exists than for the components (18) of the main circuit board (16).

2. Circuit arrangement according to Claim 1, the exchangeable circuit board (22) being electrically connected to the main circuit board (16) by at least one plug connection (20).

3. Circuit arrangement according to Claim 1 or 2, the exchangeable circuit board (22) having plug connection elements (26, 28) for connecting external signal lines, in particular data transmission lines.

4. Circuit arrangement according to one of the preceding claims, the exchangeable circuit board (22) having optical indication elements (30).

5. Circuit arrangement according to one of the preceding claims, a maximum of 25%, in particular a maximum of 15%, of the number of electronic components of the control stage being provided on the exchangeable circuit board (22).

6. Circuit arrangement according to one of the preceding claims, the board size of the exchangeable circuit board (22) corresponding at most to one third, in particular at most one quarter, of the board size of the main circuit board (16).

7. Circuit arrangement according to one of the preceding claims, it being possible, through an access opening (34) provided in a side part (10) of the housing (12), for the exchangeable circuit board to be separated from the main circuit board (16) and to be removed from the housing (12) or to be introduced into the housing (12) and to be electrically connected to the main circuit board (16), and the exchangeable circuit board (22) being arranged on a cover screen (32) for closing the access opening (34).

8. Circuit arrangement according to one of the preceding claims, the power output stage having a circuit board (14) that is populated with output stage components, is electrically connected to the main circuit board (16) of the control stage and is accommodated together with the main circuit board (16) and the exchangeable circuit board (22) of the control stage in the housing (12).

9. Mobile working machine, in particular an industrial truck, having at least one electric traction motor and/or an electric motor for operating a lifting device and/or an electric steering motor, and having a circuit arrangement according to one of Claims 1 to 8 for controlling the at least one electric motor.

## Revendications

1. Agencement de circuit destiné à commander un moyen d'entraînement à moteur électrique d'un dispositif de travail mobile, en particulier un chariot de manutention,
l'agencement de circuit comportant un étage de commande (16, 22) électronique et un étage de sortie de puissance (14), l'étage de commande électronique comportant au moins une platine principale (16), fixée dans un carter (12) de l'agencement de circuit et équipée de composants électroniques, et une platine amovible (22), reliée électriquement à la platine principale (16), mais apte à être séparée, en cas de besoin, de la platine principale (16) moyennant de faibles dépenses,
**caractérisé en ce que** la platine amovible (22) comporte un groupe de composants (24) choisis de l'étage de commande, qui en raison de leur plus grande probabilité de panne, nécessitent statistiquement un remplacement plus fréquent et un plus grand contrôle que les composants (18) de la platine principale (16).

2. Agencement de circuit selon la revendication 1, dans lequel la platine amovible (22) est reliée électriquement à la platine principale (16) par au moins un assemblage enfichable (20).

3. Agencement de circuit selon la revendication 1 ou 2, dans lequel la platine amovible (22) comporte des éléments d'assemblage enfichable (26, 28) pour le branchement de lignes de transmission de signaux externes, en particulier des lignes de transmission de données.

4. Agencement de circuit selon l'une des revendications précédentes, dans lequel la platine amovible (22) comporte des éléments d'affichage optiques (30).

5. Agencement de circuit selon l'une des revendications précédentes, dans lequel au maximum 25 %, en particulier au maximum 15 % du nombre de composants électroniques de l'étage de commande sont prévus sur la platine amovible (22).

6. Agencement de circuit selon l'une des revendications précédentes, dans lequel la dimension de la platine amovible (22) correspond au maximum à un tiers, en particulier au maximum à un quart de la dimension de la platine principale (16).

7. Agencement de circuit selon l'une des revendications précédentes, dans lequel la platine amovible est séparée de la platine principale (16) par une ouverture d'accès (34) prévue à travers une partie latérale (10) du carter (12) et peut être retirée hors du carter (12) ou introduite dans le carter (12) et peut être reliée électriquement à la platine principale (16), et dans lequel la platine amovible (22) est agencée sur un écran formant couvercle (32) destiné à fermer l'ouverture d'accès (34).

8. Agencement de circuit selon l'une des revendications précédentes, dans lequel l'étage de sortie de puissance comporte une platine (14), qui est équipée de composants de l'étage de sortie de puissance et qui est reliée électriquement à la platine principale (16) et est logée, conjointement avec la platine principale (16) et la platine amovible (22) de l'étage de commande dans le carter (12).

9. Dispositif de travail mobile, en particulier chariot de manutention, comportant au moins un moteur de translation électrique et/ou un moteur électrique pour l'actionnement d'un dispositif de levage et/ou un moteur de direction électrique et comportant un agencement de circuit selon l'une des revendications 1 à 8, destiné à commander ledit au moins un moteur électrique.
